# EUROPÄISCHE PATENTSCHRIFT

(11) **EP 1 028 603 B1**
(45) Veröffentlichungstag und Bekanntmachung des Hinweises auf die Patenterteilung: **28.08.2002**
(21) Anmeldenummer: 00200427.3
(22) Anmeldetag: 04.02.2000
(51) Int. Cl.: H05B 6/66, H02N 2/00, H04R 17/00, G05F 3/26, G05F 1/585, B05B 1/08

(54) **Schaltungsanordnung mit einem selbstschwingenden Oszillator-Schaltkreis**
Circuit with self-resonant oscillator
Circuit avec oscillator à résonance propre

(30) Priorität: 13.02.1999 DE 19906109
(43) Veröffentlichungstag der Anmeldung: 16.08.2000
(73) Patentinhaber: Philips Corporate Intellectual Property GmbH, 52064 Aachen (DE); Koninklijke Philips Electronics N.V., 5621 BA Eindhoven (NL)
(72) Erfinder: Ossmann, Martin, Philips Corporate IP GmbH, 52064 Aachen (DE); Leers, Dieter, Philips Corporate IP GmbH, 52064 Aachen (DE)
(74) Vertreter: Volmer, Georg, Dipl.-Ing.

(56) Entgegenhaltungen:
- EP-A- 0 523 732
- SU-A- 754 391
- US-A- 5 657 926

## Beschreibung

Die Erfindung betrifft eine Schaltungsanordnung mit einem selbstschwingenden Oszillator-Schaltkreis und mit einer die Oszillationsfrequenz bestimmenden Reihenschaltung aus einem Widerstand und einem Kondensator.

Aus der US-A-5 657 926 sind Beispiele für selbstschwingende Oszillator-Schaltkreise bekannt, die jeweils ein Piezoelement zur Erzeugung von Schwingungen beinhalten.

In der EP-A-0 523 732 ist ein auf einem Piezoelement angeordneter Beschleungungssensor mit einem zugehörigen Auswerteschaltkreis beschrieben. Ein Oszillator-Schaltkreis erzeugt ein Oszillatorsignal, das dem Piezoelement zugeführt wird und mit dessen Hilfe das Piezoelement zum Schwingen angeregt wird.

Aus der SU-A-754 391 ist ein Schaltkreis mit einem Piezoelement bekannt.

Weiterhin ist die eingangs erwähnte Schaltungsanordnung aus "International Rectifier", Datenblatt No. PD-6.029A, 1994 bekannt. Der Oszillator-Schaltkreis ist dort ein integrierter Schaltkreis, der mit weiteren Bauelementen, insbesondere einer Halbbrücke aus zwei MOSFET-Transistoren, zur Bildung einer Treiberschaltung erweitert ist. Der Oszillator-Schaltkreis hat einen ersten Eingang, der mit einem Anschluss des Widerstands der Reihenschaltung, einen zweiten Eingang, der mit dem anderen Anschluss des Widerstands und dem Punkt der Reihenschaltung zwischen Widerstand und Kondensator verbunden ist, und einen dritten Eingang, der mit dem anderen Anschluss des Kondensators und einem Massepotential verbunden ist. An einem Ausgang des Oszillator-Schaltkreises kann eine oszillierende Versorgungsspannung abgegriffen werden.

Diese oszillierende Versorgungsspannung soll nun einem eine Resonanzfrequenz aufweisenden elektronischen Gebilde, das ein resonantes elektronisches Bauelement oder eine resonante Anordnung aus mehreren elektronischen Bauelementen sein kann, zugeführt werden. Dann stellt sich das Problem, die Oszillationsfrequenz des Oszillator-Schaltkreises möglichst genau an die Resonanzfrequenz des zu versorgenden elektronischen Gebildes anzupassen und dabei innerhalb von Toleranzbereichen liegende Werte der verwendeten Bauelemente auszugleichen. Weiterhin soll der hierzu verwendete Schaltungsaufwand möglichst gering sein.

Diese Probleme werden dadurch gelöst, dass eine Widerstandskopplung eines Kontrollsignalausgangs des elektronischen Gebildes, der zur Lieferung eines den Schwingungszustand des elektronischen Gebildes beschreibenden Kontrollsignals dient, mit der Reihenschaltung vorgesehen ist.

Durch die als Widerstandskopplung ausgeführte Rückkopplung des Kontrollsignals wird direkt auf die Spannungswerte an der die Oszillationsfrequenz des Oszillator-Schaltkreises bestimmenden Reihenschaltung aus Widerstand und Kondensator Einfluss genommen, was zur Einstellung einer ausreichend genauen Oszillationsfrequenz in den meisten Fällen ausreicht. Bisher an dieser Stelle übliche aufwendige Ausgleichsschaltungen zum Ausgleich von Bauelementetoleranzen, insbesondere von Toleranzen der Widerstands-Kondensator-Reihenschaltung und des resonanten elektronischen Gebildes sind nun nicht mehr erforderlich.

In einer bevorzugten Ausführungsform ist vorgesehen, dass der Widerstand der Reihenschaltung mit einem ersten und einem zweiten Steuereingang des Oszillator-Schaltkreises und der Kondensator der Reihenschaltung mit dem zweiten Steuereingang und einem Masseeingang des Oszillator-Schaltkreises gekoppelt ist und dass der Kontrollsignalausgang des elektronischen Gebildes mit der Verbindung zwischen dem Widerstand und dem Kondensator der Reihenschaltung verbunden ist. Diese Ausgestaltung ist insbesondere bei der Verwendung des eingangs genannten Oszillator-Schaltkreises aus "International Rectifier", Datenblatt No. PD-6.029A, 1994 einzusetzen. Das elektronische Gebilde ist beispielsweise ein Piezotransformator. Vorzugsweise wird die erfindungsgemäße Schaltungsanordnung zur Erzeugung einer Ausgangsspannung eines Vorschaltkreises in einer Niederdruckentladungslampe verwendet.

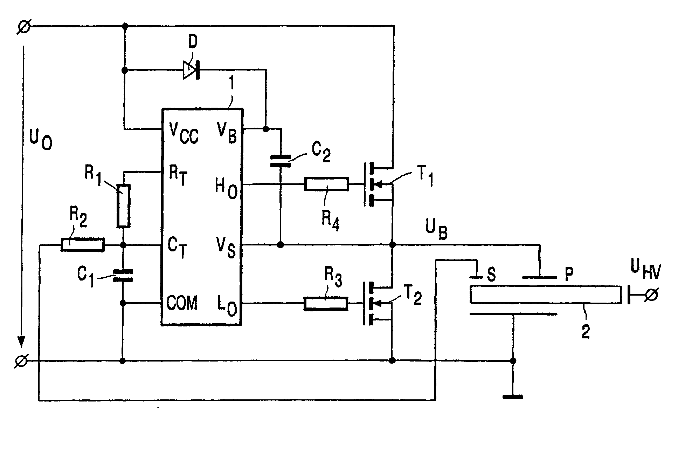

Ein Ausführungsbeispiel der Erfindung wird nachstehend anhand der Figur näher erläutert.

Die Figur zeigt eine Schaltungsanordnung mit einem selbstschwingenden Oszillator-Schaltkreis 1 vom Typ IR 2155 (siehe "International Rectifier", Datenblatt No. PD-6.029A, 1994), dem an einem Eingang V_{CC} und über eine Diode D einem Eingang V_{B} ein Potential einer Versorgungsspannung U₀ zugeführt wird. Der Eingang V_{B} ist über einen Kondensator C₂ mit einem Ausgang V_{S} verbunden, an dem eine oszillierende Versorgungsspannung U_{B} geliefert wird. Der Ausgang V_{S} ist außerdem mit dem Verbindungspunkt zwischen zwei als Halbbrücke in Reihe geschalteten MOSFET-Transistoren T₁ und T₂ verbunden. Die Reihenschaltung der Transistoren T₁ und T₂ liegt dabei zwischen dem Potential der Versorgungsspannung U₀ und einem Massepotential. Die Transistoren T₁ und T₂ werden über Widerstände R₄ und R₃ vom Oszillator-Schaltkreis 1 gesteuert. Die Oszillationsfrequenz des Oszillator-Schaltkreises 1 wird durch eine Reihenschaltung aus einem Widerstand R₁ und einem Kondensator C₁ durch Wahl geeigneter Werte an die jeweiligen Bedürfnisse angepaßt. Ein Anschluss des Widerstands R₁ ist mit einem ersten Steuereingang R_{T} des Oszillator-Schaltkreises 1 verbunden. Der andere Anschluss des Widerstands R₁ und ein Anschluss des Kondensators C₁ sind mit einem zweiten Steuereingang C_{T} des Oszillator-Schaltkreises 1 verbunden. Der andere Anschluss des Kondensators C₁ liegt auf einem Massepotential und ist mit einem Masseeingang des Oszillator-Schaltkreises 1 verbunden.

Im vorliegenden Ansführungsbeispiel wird die oszillierende Versorgungsspannung U_{B}, die am Ausgang V_{S} anliegt, einem elektronischen Gebilde 2 zugeführt, das hier ein aus einer Piezoscheibe bestehender Piezotransformator ist. Die Spannung U_{B} wird an einen an einer Flachseite der Piezoscheibe angeordneten Anschluss P geliefert, wobei ein korrespondierender Anschluss auf der anderen Flachseite der Piezoscheibe auf Massepotential liegt. An einem seitlich angeordneten Anschluss der Piezoscheibe ist eine Hochspannung U_{HV} abgreifbar. Diese wird in einem bevorzugten Anwendungsfall in Vorschaltkreisen von Niederdruckentladungslampen zur Spannungsversorgung verwendet.

Um eine genaue Einstellung der Oszillationsfrequenz des Oszillator-Schaltkreises 1 auf die Resonanzfrequenz des Piezo-Transformators 2 zu gewährleisten und insbesondere Toleranzen der Werte des Widerstandes R₁ und des Kondensators C₁ sowie der Resonanzfrequenz des Piezotransformators 2 auszugleichen, wird an einem Kontrollsignalausgang S des Piezotransformators 2 eine den Schwingungszustand des Piezotransformators beschreibendes Kontrollsignal abgegriffen und über eine durch einen Widerstand R₂ repräsentierte Widerstandskopplung der Reihenschaltung aus dem Widerstand R₁ dem Kondensator C₁ zugeführt. Dabei ist der Widerstand R₂ mit dem Punkt zwischen dem Widerstand R1 und dem Kondensator C₁ verbunden. Diese einfache Rückkopplung reicht aus, um die Oszillationsfrequenz des Oszillator-Schaltkreises 1 auf die Resonanzfrequenz des Piezotransformators 2 anzupassen und Toleranzabweichungen auszugleichen.

## Patentansprüche

1. Schaltungsanordnung mit einem selbstschwingenden Oszillator-Schaltkreis (1) und mit einer die Oszillationsfrequenz bestimmenden Reihenschaltung aus einem Widerstand (R₁) und einem Kondensator (C₁),
**dadurch gekennzeichnet,**
**dass** der Oszillator-Schaltkreis (1) zur Lieferung einer oszillierenden Versorgungsspannung (U_{B}) an ein eine Resonanzfrequenz aufweisendes elektronisches Gebilde (2) dient und dass eine Widerstandskopplung (R₂) eines Kontrollsignalausgangs (S) des elektronischen Gebildes (2), der zur Lieferung eines den Schwingungszustand des elektronischen Gebildes beschreibenden Kontrollsignals dient, mit der Reihenschaltung vorgesehen ist.

2. Schaltungsanordnung nach Anspruch 1,
**dadurch gekennzeichnet,**
**dass** der Widerstand (R₁) der Reihenschaltung mit einem ersten und einem zweiten Steuereingang (R_{T}, C_{T}) des Oszillator-Schaltkreises (1) und der Kondensator (C_{T}) der Reihenschaltung mit dem zweiten Steuereingang (C_{T}) und einem Masseeingang des Oszillator-Schaltkreises (COM) gekoppelt ist und
**dass** der Kontrollsignalausgang des elektronischen Gebildes (2) mit der Verbindung zwischen dem Widerstand (R₁) und dem Kondensator (C₁) der Reihenschaltung verbunden ist.

3. Schaltungsanordnung nach Anspruch 1 oder 2,
**dadurch gekennzeichnet,**
**dass** das elektronische Gebilde (2) ein Piezotransformator ist.

4. Verwendung der Schaltungsanordnung nach einem der Ansprüche 1 bis 3 zur Erzeugung einer Ausgangsspannung eines Vorschaltkreises in einer Niederdruckentladungslampe.

## Claims

1. A circuit arrangement with a self-resonant oscillator circuit (1) and a series combination of a resistor (R₁) and a capacitor (C₁), which series combination determines the oscillation frequency, **characterized in that**
the oscillator circuit (1) serves to supply an oscillating supply voltage (U_{B}) to an electronic device (2) which exhibits a resonant frequency, and **in that**
a control signal output (S) of the electronic device (2) has a resistive coupling (R₂) to the series combination, which control signal output serves to supply a control signal which is representative of the oscillation mode of the electronic device.

2. A circuit arrangement as claimed in Claim 1, **characterized in that**
the resistor (R₁) of the series combination is coupled to a first and a second control input (R_{T}, C_{T}) of the oscillator circuit (1) and the capacitor (C_{T}) of the series combination is coupled to the second control input (C_{T}) and a ground input of the oscillator circuit (COM), and **in that**
the control signal output of the electronic device (2) is connected to the node between the resistor (R₁) and the capacitor (C₁) of the series combination.

3. A circuit arrangement as claimed in Claim 1 or 2, **characterized in that** the electronic device (2) is a piezoelectric transducer.

4. A use of the circuit arrangement as claimed in any one of the Claims 1 to 3 for the generation of an output voltage of a ballast circuit in a low-pressure discharge lamp.

## Revendications

1. Circuit avec oscillateur à résonance propre (1) et avec un montage en série déterminant la fréquence d'oscillation et composé d'une résistance (R₁) et d'un condensateur (C₁),
**caractérisé en ce**
**que** l'oscillateur (1) sert à fournir une tension d'alimentation oscillante (U_{B}) à une entité électronique (2) présentant une fréquence de résonance et qu'il est prévu avec le montage en série un couplage de résistance (R₂) d'une sortie d'un signal de contrôle (S) de l'entité électronique (2) qui sert à fournir un signal de contrôle décrivant l'état de résonance de l'entité électronique.

2. Circuit selon la revendication 1,
**caractérisé en ce**
**que** la résistance (R₁) du montage en série est couplée avec une première et une deuxième entrées de commande (R₁, C₁) de l'oscillateur (1) et le condensateur (C_{T}) du montage en série avec la deuxième entrée de commande (C_{T}) et une entrée de masse de l'oscillateur (COM) et
**que** la sortie du signal de contrôle de l'entité électronique (2) est reliée à la liaison entre la résistance (R₁) et le condensateur (C₁) du montage en série.

3. Circuit selon l'une des revendications 1 ou 2,
**caractérisé en ce**
**que** l'entité électronique (2) est un piézotransformateur.

4. Mise en oeuvre du circuit selon l'une des revendications 1 à 3 de production d'une tension de sortie d'un circuit en amont dans une lampe de décharge à basse pression.
